# EUROPEAN PATENT APPLICATION

(11) **EP 1 496 133 A1**
(43) Date of publication of application: **12.01.2005**
(21) Application number: 04103104.8
(22) Date of filing: 01.07.2004
(51) Int. Cl.: C23C 14/24

(54) **Assembly for crucible used for evaporation of raw materials.**

(30) Priority: 04.07.2003 EP 03102003; 04.07.2003 EP 03102004
(71) Applicant: AGFA-GEVAERT, 2640 Mortsel (BE)
(72) Inventor: Aerts, Bart Agfa-Gevaert, 2640, Mortsel (BE); Lamotte, Johan Agfa-Gevaert, 2640, Mortsel (BE)

(57) **Abstract**

An assembly for vaporizing raw materials in order to prepare vapor deposited phosphor materials comprises a crucible provided with two plates or covers, wherein one thereof is an outermost plate or cover provided with a perforation pattern, selected from the group consisting of one or more slits, in series or in parallel, and of openings having same or different diameter, randomly or regularly distributed over said cover, moreover covering said crucible having a bottom and surrounding side walls with a height "h" and wherein said crucible contains raw materials, is characterized in that a second plate is mounted internally in the crucible at a distance from said outermost cover plate being less than 2/3 of said side wall height "h".

## Description

### FIELD OF THE INVENTION

The present invention relates to a solution for manufacturing phosphor or scintillator materials, excellent in speed or sensitivity, by evaporation from from liquefied raw materials present in heated crucible(s).

### BACKGROUND OF THE INVENTION

In physical vapour deposition (PVD) as well as in chemical vapour deposition (CVD) techniques, factors providing deposition of homogeneous phosphor or scintillator coating compositions and homogeneous layer thicknesses over the entire surface thereof, besides use of especially designed electrically heated crucible(s) are related with the distance determining the profile of the vapour cloud at the position of the substrate, as has e.g. been described in EP-Applications Nos. 03 100 723, filed March 20, 2003 and 04 101 138, filed March 19, 2004.

Average values of shortest distances between crucible(s) and substrate are preferably in the range of from 5 to 10 cm. Too large distances would lead to loss of material and decreased yield of the process, whereas too small distances would lead to too high a temperature of the substrate.

It has been established in EP-Application 03 102 003, filed July 4, 2003 that care should be taken in order to avoid "spot errors" or "pits", resulting in uneven deposit of phosphors or scintillators, due to spitting of the liquefied raw materials present in the heated container(s). Besides physical presence of an undesired unevenness at the surface, differences in speed or sensitivity may indeed lay burden on its use as a screen, plate or panel for use in diagnostic imaging, especially when those phosphors are suitable for use in direct radiography as scintillators, in intensifying screens as prompt emitting phosphors or in storage panels as stimulable phosphors, used in computed radiography (CR).

An assembly comprising two plates or covers, one of which being an outermost plate or cover, and both, at least in part having a perforation pattern over a surface area covering an open side of a crucible having a bottom and surrounding side walls containing raw materials, wherein said outermost cover is mounted at a distance farther from the said crucible than said cover covering said open side of a crucible, and wherein both covers are mounted versus each other, so that, when viewed through an axis in a direction perpendicular to the bottom of the crucible from a distance to said outermost cover of at least 10 times the distance between said two plates or covers, its contents cannot be observed, has been offered as a solution for that problem.

It is however an ever lasting demand, not only to provide homogeneity in speed over the whole surface of the phosphor plate, but also to provide the highest attainable speed possible for the same coating amount of evenly distributed vapor deposited phosphor layers on a phosphor plate.

### OBJECTS AND SUMMARY OF THE INVENTION

Therefore it is an object of the present invention to provide a tool, besides preventing undesired "spots" or "pits" from reaching the substrate or support for phosphors or scintillators to be prepared while applying CVD or PVD techniques especially in vacuum conditions in a vacuum chamber, in order to vaporise and deposit scintillator or phosphor materials on substrates, providing plates or panels having the highest possible sensitivity.

The above-mentioned advantageous effects have been realized by making use of a particular assembly of covers in combination with heated crucibles containing raw materials as starting materials, wherein said assembly has the specific features set out in claim 1. Specific features for preferred embodiments of the invention are set out in the dependent claims.

Further advantages and embodiments of the present invention will become apparent from the following description and drawings.

### BRIEF DESCRIPTION OF THE DRAWINGS

Fig. 1 shows a 3D view of the improved crucible configuration, wherein (1) represents the folded tantalum crucible; (2) the container of the crucible, (3) the lip (present at both sides of the crucible), (4) the cover plate with (5) the slit therein. The guiding plate (6), further directs the vapour stream towards the substrate.
Fig. 2 shows a side view (cut through position A from Fig. 1)
Fig. 3 shows a front view (cut through position B from Fig. 1)
Fig. 4 shows a side view (cut through position A) for the inventive crucible configuration with internally positioned, folded tantalum plate (7).
Fig. 5 shows a front view (cut through position B) for the same inventive crucible configuration with internally positioned, folded tantalum plate (7) as in Fig. 4.

### DETAILED DESCRIPTION OF THE INVENTION

According to the present invention an assembly comprising a crucible provided with two plates or covers is provided, wherein one thereof is an outermost plate or cover provided with a perforation pattern, selected from the group consisting of one or more slits, in series or in parallel, and of openings having same or different diameter, randomly or regularly distributed over said cover, moreover covering said crucible having a bottom and surrounding side walls having a height "h" and wherein said crucible contains raw materials, characterized in that a second plate is mounted internally in the crucible at a distance from said outermost cover plate of less than 2/3 of said height "h". Most preferred in said outermost cover is a perforation pattern, wherein one or more slits, in series or in parallel, are regularly distributed over said cover. Most preferred is presence of one long slit, whether or not interrupted at regular sites and even most preferred is one long slit, parallel with the longest side or length of the crucible.

In a more preferred embodiment the assembly according to the present invention said assembly has said second plate mounted internally in the crucible at a distance from said outermost cover plate of less than 1/3 of said height "h".

According to the present invention in said assembly, said second plate is mounted internally in the crucible at a distance from said outermost cover plate, being not less than 1/10 of said height "h". In that case the distance between the cover plate and the second, inernally mounted plate would be too small, resulting in a decreasing depositing yield.

According to the present invention in one embodiment of said assembly, said bottom, said outermost cover and said second plate are arranged in parallel versus each other.

According to the present invention in another embodiment of said assembly said second plate is not parallel versus said outermost cover, at least in one direction.

With respect to the dimensions of the crucible, in one embodiment the assembly according to the present invention has slits having a combined dimension in a range between 10 and 90 % of its largest dimension and between 1 and 90 % of its smallest dimension.

In another, more preferred embodiment according to the present invention, said slits have a combined dimension in a range between 20 and 80 % of its largest dimension and between 5 and 50 % of its smallest dimension and even slits having a combined dimension in a range between 40 and 60 % of its largest dimension and between 5 and 15 % of its smallest dimension are applied, depending on the needs.

It is clear that material compositions of covering plates as well as of the crucibles should be resistant to physical influences, in that the materials should be refractory materials. Desired refractory materials are chosen therefore and are selected from the group of materials consisting of Mo, Nb, Ta and W. An ultimate choice of a suitable material for use as a refractory cover material mostly depends on its manutention as the cover should be brought into the desired form (e.g. deformation by folding or bending of plates of the desired thickness in a so-called "nip-zone" or between rollers or other "flattening means" or "bending means") in order to be suitable for use as a cover onto a container, boat or crucible of raw materials to be vaporized.

An assembly according to the present invention is thus provided with crucible and cover plates, composed of a refractory material, being a metal or metal alloy selected from the group consisting of tantalum (Ta), molybdene(Mo), niobium(Nb), tungsten (W) and heat-resistant stainless steel. As a refractory material a metal or metal alloy, covered with a silicide layer or a carbide layer of said metal or metal alloy may also be useful. It is thus not excluded that the composition would be different for the crucible and at least one of the covers, but in one embodiment the assembly according to the present invention, is an assembly wherein said crucible and said plates are composed of the same refractory material. So in a more particularly preferred embodiment according to the present invention for said assembly, said (refractory) material is tantalum.

In a further embodiment the assembly according to the present invention is mounted so that said crucible and said plates are mounted between an electrode pair. In that way heating proceeds as set out in EP-Application 03 102 003, filed July 4, 2003, wherein said electrode pair has been described as being connected with said crucible via electrode clamps at exterior sites of side walls located opposite with respect to each other, wherein said sites are extending as lips at side walls of the crucible, and wherein said clamps are connectable with electrodes for heating said crucible, wherein the improvement as disclosed therein is related with the cross-section of each of said lips between between crucible wall and clamp which is reduced with at least 5 %. Same measure is advantageously applied in the assembly configuration as disclosed in the present invention. Said reduction with at least 5 % can be realized by reduction of the cross-section of each of said lips between between crucible wall and electrode clamp, by providing each lip with perforations. With respect to the level of the mounted internal plate, it is clear that at the start of the heating procedure, followed by the vaporizing step, the surface level of the raw materials may be higher than the internally mounted plate. This may be in favor of initial heating and melting. In an evaporation method by electric resistance heating as normally applied, said crucible is advantageously filled with raw materials up to at most 80 % of its total volume, determined by its inner surface of its bottom and height of its inner side walls. Therein electric heating normally proceeds up to a temperature exceeding the melting temperature of said raw materials with at least 10°C.

Loss of energy within the crucible assemby may further be avoided in this initial heating procedure in that the assembly of the present invention may be provided with a non-perforated cover as a closing cover or "shutter", which is taken away as soon as the vapor deposition step can start. In a further step it is not excluded that the level of the internally mounted plate extends above the level of raw materials: said crucible may be filled with raw materials up to at most 50 % of its total volume, determined by its inner surface of its bottom and height of its inner side walls while electric heating proceeds up to a temperature exceeding the melting temperature of said raw materials in the range from 20°C up to 100°C above the melting temperature of said materials.

There are two ways or methods in order to avoid changes of the level of the internally mounted plate versus the level of the molten raw materials. One method makes use of varying the level of the internally mounted plate while the vaporizing step is proceeding. Another method makes use of a replenishing step, wherein the raw materials are added as powders or tablets to the crucible, as has been disclosed in EP-Application No. 03 100 723, filed March 20, 2003. Therein it has been told that even when no change in composition in the thickness direction of the phosphor or scintillator plate is desired, it is clear that the raw material containing crucible(s) become exhausted during the physical vapour deposition process, set forth hereinbefore. Therefore "replenishment" of the crucible(s) is provided, e.g. by addition of raw material components in powdery form, in form of grains or crystals or in form of pastilles containing caked powder or grain mixtures, in favor of maintaining homogeneity during the further evaporation process as otherwise, differences in dopant (Europium) concentrations may appear while the coating process is running furtheron. Methods in order to "replenish" the crucible(s) have e.g. been described in US-A 4,430,366, in DE-A 1 98 52362 and in US-A 2003/0024479. An example of an available replenishing unit has been illustrated in the said EP-Application No. 03 100 723, filed March 20, 2003, as can be seenmore particularly in the Figures 8 and 9, wherein, as a non-limitative example, also applicable in the other Figures, a source of material supply (26) and a guiding mechanism for raw material supply (27) have been mounted in the vacuum deposition chamber.

With respect to those raw material(s) contained in the crucibles or boats, said raw materials are selected from the group consisting of alkali halides, earth alkali halides, halides, oxides or oxihalides of earth metals; halides, oxides or oxihalides of the group of elements of the lanthanide series and combinations thereof. It is further clear that these raw materials should melt at the designed high process temperatures (in the order of at least 300°C, more preferably at least 450°C and even most preferably in the range up to 700-900°C) in order to be vaporized and deposited afterwards onto a cooled substrate support. Formation of e.g. "mixed melt" crystals of crucible material and raw materials contained in the crucibles should clearly not be appreciated, as presence of crucible material in deposited layers would be a source of undesired contamination. Besides being physically inert, it is clear that the cover material as well as the crucible material should be chemically inert, in that chemical reactions between contacting raw materials and crucible materials should be made impossible, as otherwise the composition of the deposition product onto the cooled substrate would not be under controll. Besides such an uncontrollable composition, homogeneity or uniformity of the deposited layers should be out of controll. It is recommended, in favor of homogeneity, and, more particularly, in favor of homogeneity of dopant distribution troughout the deposited phosphor or scintillator layer to follow the methods which have been disclosed in WO 00/16904, filed June 19, 2000; and in EP-Applications Nos. 03 104 842 and 03 104 859, both filed December 19, 2003 and in EP-Applications Nos. 04 100 675, 04 100 678 and 04 100 679, all of those last three applications having been filed February 20, 2004. In those unpublished EP-Applications, as in EP-Application Nos. 03 104 842 a method has been disclosed for manufacturing a storage phosphor for use in a photostimulable phosphor screen or panel comprising a support and a storage phosphor layer, wherein a dopant or activator is incorporated more homogeneously in amorphous and in crystalline phosphors as well, starting with a mixing step of said matrix component and activator component in stoechiometric ratios in order to provide a desired phosphor composition; and more particularly in order to prepare a CsBr:Eu²⁺ phosphor having an optimised sensitivity with respect to its particle size. In EP-Application No. 03 104 859 a method for producing CsX:Eu stimulable phosphors and screens or panels has been disclosed in order to provided phosphors as powder phosphors or vapour deposited needle-shaped phosphors suitable for use in image forming methods for recording and reproducing images of objects made by high energy radiation, wherein said CsX:Eu stimulable phosphors are essentially free from oxygen in its crystal structure, and wherein X represents a halide selected from the group consisting of Br, Cl and combinations thereof, and wherein the method further comprises the steps of mixing CsX with a compound or combinations of compounds having as a composition CsₓEu_{y}X'_{x+αy}, wherein the ratio of x to y exceeds a value of 0.25, wherein α ≥ 2 and wherein X' is a halide selected from the group consisting of Cl, Br and I and combinations thereof; heating said mixture at a temperature above 450 °C; cooling said mixture, and optionally annealing and recovering said CsX:Eu phosphor.

In EP-Application No. 04 100 675 it has been established that storage phosphor particles suitable for use in coated layers of stimulable phosphor screens or panels, in favour of high relative sensitivity, advantageously contain at the surface of the phosphor particles and in their inner volume, as components composing the said phosphor, a matrix component and a dopant or activator element that is homogeneously incorporated, wherein preference is given to particles having an aspect ratio of more than 2:1, said aspect ratio being defined as a ratio of 2 largest sizes of said particles, said sizes being taken in 3 dimensions perpendicular to each other, provided that one of said 2 largest sizes is smaller than 10 µm.

In EP-Application No. 04 100 678 a method for producing CsX:Eu stimulable phosphors and screens or panels has been described wherein said screens or panels have been provided with said phosphors as powder phosphors or vapour deposited needle-shaped phosphors suitable for use in image forming methods for recording and reproducing images of objects made by high energy radiation, wherein said CsX:Eu stimulable phosphors are essentially free from oxygen in their crystal structure, and wherein X represents a halide selected from the group consisting of Br, Cl and combinations thereof, and wherein the method further makes use of starting compounds or combinations of starting compounds having as a composition CsₓEu_{y}X'_{x+αy}, wherein the ratio of x to y exceeds a value of 0.25, wherein α ≥ 2 and wherein X' is a halide selected from the group consisting of Cl, Br and I and combinations thereof; heating said mixture at a temperature above 450 °C; cooling said mixture, and optionally annealing and recovering said CsX:Eu phosphor.

In EP-Application No. 04 100 679, a method for producing CsX:Eu stimulable phosphors and screens or panels has been described wherein those screens or panels are provided with said phosphors as powder phosphors or vapour deposited needle-shaped phosphors suitable for use in image forming methods for recording and reproducing images of objects made by high energy radiation, wherein said CsX:Eu stimulable phosphors are essentially free from oxygen in their crystal structure, and wherein X represents a halide selected from the group consisting of Br, Cl and combinations thereof, and wherein the method further comprises the steps of mixing CsX with a compound or combinations of compounds having as a composition CsₓEu_{y}X'_{x+αy}, wherein the ratio of x to y exceeds a value of 0.25, wherein α ≥ 2 and wherein X' is a halide selected from the group consisting of Cl, Br and I and combinations thereof; heating said mixture at a temperature above 450 °C; cooling said mixture, and optionally annealing and recovering said CsX:Eu phosphor.

The stimulable phosphor may contain a metal oxide such as aluminum oxide, silicon dioxide, and/or zirconium oxide in an amount of 0.5 mol or less per one mole of cesium. Moreover minor amounts of alkali metals other than Cs (Li, Na, K, Rb) and each of alkaline earth metals (Mg, Ca, Sr, Ba) may be present, but as has been shown, in amounts of less than 10 ppm and less than 2 ppm, respectively, in the CsBr:Eu matrix. Each of rare earth elements other than Eu and each of other elements may further be present in same CsBr:Eu matrix in amounts, but in normal conditions, in amounts of less than 20 ppm and less than 10 ppm, respectively.

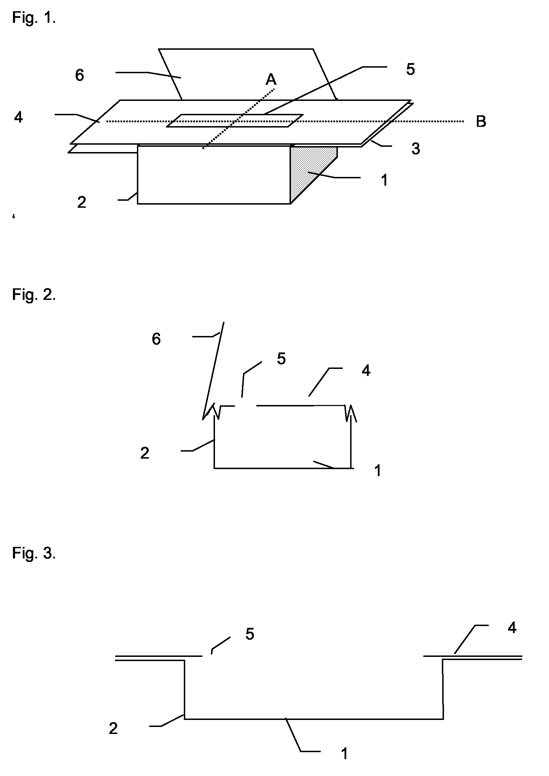

The assembly according to the present invention is, in a further advantageous embodiment thereof provided with a guiding plate. The guiding plate (6), shown in Figures 1, 2 and 4 further directs the vapour stream towards the substrate and avoids losses of material (if not deposited onto the substrate support).

### Examples

While the present invention will hereinafter be described in connection with preferred embodiments thereof, it will be understood that it is not intended to limit the invention to those embodiments.

### Comparative Example 1

This example describes the state-of-the art method performed in order to obtain a photostimulable CsBr:Eu imaging plate.

A CsBr:Eu photostimulable phosphor layer was deposited in a vacuum chamber via thermal vapour deposition on an anodized aluminum support that rotates around an axis perpendicular to and going through the centre of the support starting from a mixture of CsBr and EuOBr as raw materials.

The support was anodized aluminum having a thickness of 280 µm, a width of 18 cm and a length of 24 cm. The aluminum support was mounted, against a substrate holder, rotating in a controlled way by means of a motor, around its axis. The aluminum was rotating with an angular speed of 12 rotations per minute. The support was heated by means of a resistively heated heating plate at 240°C.

A mixture of CsBr and EuOBr, in a CsBr/EuOBr 99.5%/0.5% ratio by weight percentage was used as a raw material mixture to become vaporized.

The mixture was placed in a folded tantalum crucible (1). The container (2) of the crucible had a length of 150 mm, a width of 60 mm and a depth of 35 mm. In order to connect the crucible and the electrodes, the crucible had a lip (3) with a length of 25 mm and a width of 60 mm at both sides of the crucible. The crucible (1) was covered with a cover plate (4) having as dimensions 60 mm x 200 mm further having one slit (5) therein with a length of 100 mm and a width of 7 mm. The crucible (1) was further provided with a guiding plate, guiding the vapour stream towards the substrate.
The distance between the container and the substrate was about 15 cm. The crucible was placed at the circumference of a circle described by an edge of the rotating substrate.

Under vacuum pressure (a pressure of 2 x 10⁻¹ Pa was maintained as an equilibrium between a continuous inlet of argon gas into the vacuum chamber and continuous pumping in order to evacuate said argon gas) and at a sufficiently high temperature of the vapour source (710°C, measured with a thermocouple protected with a tantalum cover) the obtained vapour was directed towards the rotating substrate and was deposited thereon.

A CsBr:Eu stimulable phosphor layer having a coverage of 211 mg/cm² was deposited onto the support.

The stimulable phosphor layer shows a blue luminescence under UV radiation.

The sensitivity of the screen was measured in the following way: the screen was homogeneously exposed with a dose of ca. 50 mR at 80 kVp. Read-out was done with a flying spot scanner. In the scanner, the scanning light source was a 30 mW diode laser emitting at 685 nm. A 3-mm BG-39® (trade name of Schott) filter coated at both sides with a dielectrical layer was used in order to efficiently separate the stimulation light from the screen emission light. The scan-average level (SAL) was determined as the average signal produced by the screen field in the photomultiplier tube. This average signal was compared with the signal generated by an Agfa powder imaging plate. A sensitivity of 436 % compared with the Agfa powder imaging plate was obtained, representing a remarkable speed increase!

### Inventive Example 2 - 9

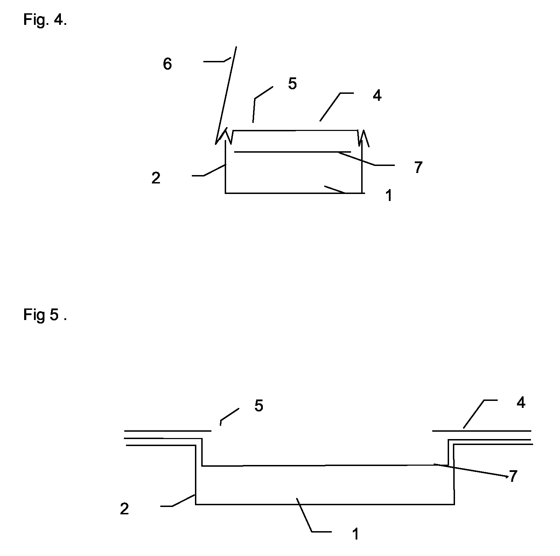

Same experiments were performed as in the comparative Example 1, except that between the crucible cover (4) and the crucible (1) an additional folded tantalum plate (7) having a width of 46 mm was fixed as shown in Figures 4 and 5. This internal tantalum plate (7) was folded in such a way that it comes into the container, as shown in Figures 4 and 5.

In the inventive examples 2 to 9 the distance between the upper side of the crucible and the internal plate was varied as shown in Table 1 hereinafter.

**Table 1**

| Example No. | Distance between top of crucible and internal Ta- plate (7) | Coverage of plate with needle-shaped phosphor (mg/cm²) | Sensitivity % SAL increase versus powder phosphor plate |
|---|---|---|---|
| 1 (comp.) | No internal plate | 211 | 436 |
| 2 | 30mm | 223 | 416 |
| 3 | 20mm | 224 | 609 |
| 4 | 20mm | 227 | 580 |
| 5 | 20mm | 224 | 617 |
| 6 | 10mm | 224 | 651 |
| 7 | 10mm | 230 | 676 |
| 8 | 10mm | 220 | 605 |
| 9 | 10mm | 206 | 610 |

Apart from a more homogeneous temperature distribution in the crucible (observed visually as the crucible glows up homogeneously), presence of the internal tantalum plate (7) makes the sensitivity of the deposited plate increase, when the distance from the top of the crucible to the internal plate 7 decreases as can be concluded from the figures in the Table 1.

A smaller distance between the top of crucible and the internal tantalum plate (7) clearly provides an excellent and remarkably improved speed with respect to the plate sensitivity without internal tantalum plate and makes speed differences between needle-shaped phosphors and powder phosphors further increase.

Having described in detail preferred embodiments of the current invention, it will now be apparent to those skilled in the art that numerous modifications can be made therein without departing from the scope of the invention as defined in the appending claims.

### PARTS LIST

- (1): folded tantalum crucible
- (2): container of the crucible
- (3): lip (present at both sides of the crucible)
- (4): cover plate
- (5): slit in the cover plate
- (6): guiding plate

## Claims

1. An assembly comprising a crucible provided with two plates or covers, wherein one thereof is an outermost plate or cover provided with a perforation pattern, selected from the group consisting of one or more slits, in series or in parallel, and of openings having same or different diameter, randomly or regularly distributed over said cover, moreover covering said crucible having a bottom and surrounding side walls having a height "h" and wherein said crucible contains raw materials, **characterized in that** a second plate is mounted internally in the crucible at a distance from said outermost cover plate of less than 2/3 of said height "h".

2. Assembly according to claim 1, wherein said second plate is mounted internally in the crucible at a distance from said outermost cover plate of less than 1/3 of said height "h".

3. Assembly according to claim 1, wherein said second plate is mounted internally in the crucible at a distance from said outermost cover plate, not less than 1/10 of said height "h".

4. Assembly according to any one of the claims 1 to 3, wherein said bottom, said outermost cover and said second plate are arranged in parallel versus each other.

5. Assembly according to any one of the claims 1 to 3, wherein said said second plate is not parallel versus said outermost cover, at least in one direction.

6. Assembly according to any one of the claims 1 to 5, wherein said slits have a combined dimension in a range between 10 and 90 % of its largest dimension and between 1 and 90 % of its smallest dimension.

7. Assembly according to any one of the claims 1 to 5, wherein said slits have a combined dimension in a range between 20 and 80 % of its largest dimension and between 5 and 50 % of its smallest dimension.

8. Assembly according to any one of the claims 1 to 7, wherein said crucible and said plates are composed of a refractory material, being a metal or metal alloy selected from the group consisting of tantalum (Ta), molybdene(Mo), niobium(Nb), tungsten (W) and heat-resistant stainless steel.

9. Assembly according to any one of the claims 1 to 7, wherein said crucible and said plates are composed of the same refractory material.

10. Assembly according to claim 9, wherein said material is tantalum.

11. Assembly according to any one of the claims 1 to 10, wherein said crucible and said plates are mounted between an electrode pair.

12. Assembly according to any one of the claims 1 to 10, wherein said assembly is further provided with a guiding plate.
